# EUROPEAN PATENT APPLICATION

(11) **EP 2 139 303 A1**
(43) Date of publication of application: **30.12.2009**
(21) Application number: 08722922.5
(22) Date of filing: 28.03.2008
(51) Int. Cl.: H05H 1/46, C23C 16/505, H01L 21/205, H01Q 21/12

(54) **PLASMA GENERATING APPARATUS AND PLASMA FILM FORMING APPARATUS**

(30) Priority: 30.03.2007 JP 2007091402
(71) Applicant: Mitsui Engineering & Shipbuilding Co., Ltd., Chuo-ku Tokyo 104-8439 (JP)
(72) Inventor: MORI, Yasunari, Tamano-shi Okayama 706-8651 (JP); TAKIZAWA, Kazuki, Tamano-shi Okayama 706-8651 (JP)
(74) Representative: Kastel, Stefan
(86) International application number: PCT/JP2008/056063
(87) International publication number: WO 2008/123411

(57) **Abstract**

A plasma generating apparatus is provided with an impedance matching member, which is connected to a feeding line that supplies an antenna element with a high frequency signal, and has variable characteristic parameters for impedance matching; a distribution wire, which is arranged corresponding to the impedance matching member and connects the impedance matching member with at least two antenna elements; and a control section which changes at the same time impedance matching statuses of at least the two antenna elements connected to the impedance matching member through the distribution wire by changing the characteristic parameters of the impedance member. Thus, the number of impedance matching devices is smaller than that of the antenna elements, and a mechanism relating to impedance matching is made relatively small.

## Description

### TECHNICAL FIELD

The present invention relates to a plasma generating apparatus configured to be used for a variety of processing (e.g., CVD, Etching and Spattering) executed in producing a variety of devices (e.g., semiconductor device, a liquid-crystal display (LCD) device and a solar battery). Additionally, the present invention relates to a plasma film forming apparatus composed of the plasma generating apparatus.

### BACKGROUND ART

An electromagnetic wave coupled-type apparatus has been used as a semiconductor device producing apparatus using plasma (e.g., a chemical vapor deposition (CVD) apparatus). The electromagnetic wave coupled-type apparatus is provided with an antenna element for generating plasma. Also, a large-size semiconductor device producing apparatus, configured to execute a variety of processing using plasma, has been demanded for processing a large-area substrate in accordance with an expanding field such as LCD devices and amorphous solar batteries.

The large-size semiconductor device producing apparatus uses a high-frequency signal having frequency of 10MHz-2.5GHz. The antenna element accordingly emits an electromagnetic wave having the short wavelength. It is thereby further important to uniformly control plasma density distribution which affects uniformity of a variety of processing (e.g., film formation).

In response to this, patent documents 1 and 2, for instance, exemplify plasma generating apparatuses for achieving generation of large-area plasma. Specifically, the plasma generating apparatuses are configured to uniform a spatial distribution of an electromagnetic wave using an array antenna for generating large-area plasma. In this case, the array antenna is composed of a plurality of antenna elements disposed on the same plane. Additionally, each of the antenna elements is formed in a rod shape and the surface thereof is covered with a dielectric. The plasma generating apparatuses, described in the patent documents 1 and 2, are provided with an impedance matching device, respectively. The impedance matching device is configured to adjust a property parameter, affecting an impedance matching condition, for reducing reflected power to be 0% in supplying high-frequency power (i.e., for achieving the best condition of impedance matching).

### <Patent Document 1>

Japan Laid-open Patent Publication No. 2004-349199

### <Patent Document 2>

Japan Laid-open Patent Publication No. 2005-149887

### DISCLOSURE OF THE INVENTION

### <Technical Problem>

According to the plasma generating apparatuses of the patent documents 1 and 2, each of the antenna elements is provided with an impedance matching device for adjusting its impedance matching condition. To generate larger-area plasma using the array antenna, the array antenna is obviously required to increase the large number of antenna elements composing the array antenna. In other words, the conventional plasma generating apparatuses, described in the patent documents 1 and 2, have been required to increase the number of the impedance matching devices in accordance with increase of the number of the antenna elements, because each of the antenna elements is provided with an impedance matching device. When the number of the impedance matching devices is increased, a control system, configured to regulate each of the impedance matching devices, will be accordingly complex. Thus, the conventional plasma processing apparatuses using the array antenna have been required to increase the number of the impedance matching devices in addition to the number of the antenna elements for generating large-area plasma. As a result, an impedance-matching related mechanism has been accordingly large in the conventional plasma processing apparatuses.

To solve the aforementioned drawbacks, an object of the present invention is to provide a plasma generating apparatus for generating plasma using an array antenna composed of a plurality of antenna elements. In the plasma generation apparatus, the number of impedance matching devices is less than the number of antenna elements, and an impedance-matching related mechanism is relatively compact. Additionally, another object of the present invention is to provide a plasma film forming apparatus using the plasma generating apparatus.

### <Solution to Problem>

To achieve the aforementioned objects, the present invention provides a plasma generating apparatus using an antenna array including a plurality of antenna elements aligned on an identical plane. Each of the antenna elements composed of a rod-shaped conductor with a surface thereof covered with a dielectric. The plasma generating apparatus is provided with a high-frequency power source for generating a high-frequency signal to be supplied to each of the antenna elements of the antenna array, impedance matching members connected to feeding lines for supplying the high-frequency signal to the antenna elements, the impedance matching members configured to change a property parameter used for impedance matching, distribution wires correspondingly disposed to the impedance matching members, respectively, each of the distribution wires connecting each of the impedance matching members and at least two antenna elements, and a control unit configured to simultaneously adjust impedance matching conditions of at least two of the antenna elements connected to each of the impedance matching members through each of the distribution wires by changing the property parameter of each of the impedance matching members.

The plasma generating apparatus is preferably further provided with a distributor for distributing a high-frequency signal generated by the high-frequency power source to the feeding lines. Each of the impedance matching members is preferably correspondingly provided to each of the feeding lines.

Moreover, each of the distribution wires preferably includes a single or plurality of branch sections between each of the impedance matching members and the antenna elements, and the high-frequency signal is preferably two-directionally distributed in each of the single or plurality of the branch sections

Furthermore, each of the distribution wires is preferably composed of a plate conductor, and the plate conductor is preferably two-directionally branched in each of the single or plurality of the branch sections.

Furthermore, a width of the plate conductor on a side of the antenna elements with a reference to each of the branch sections is preferably reduced to a half of that of the plate conductor on a side of the impedance matching members with a reference to each of the branch sections. The width is defined in a perpendicular direction to a travel direction of the high-frequency signal to be carried from each of the impedance matching member to the antenna elements.

Furthermore, path length of the high-frequency signal, extending from each of the impedance matching members to the corresponding antenna elements in each of the distribution wires, is preferably equal to or less than one-tenth of the wavelength of a high-frequency signal.

Furthermore, the property parameter is preferably a capacity parameter used for impedance matching, and each of the impedance matching members includes a capacitance element configured to change the capacity parameter.

The present invention also provides a plasma film forming apparatus including a chamber accommodating the plasma generating apparatus therein and means for supplying material gas and reaction gas into the chamber. In the plasma film forming apparatus, at least either of the material gas and the reaction gas is provided to plasma generated by the plasma generating apparatus, and film formation processing is executed with respect to a surface of a predetermined substrate disposed in the chamber.

### <Effects of Invention>

According to the present invention, it is possible to provide a plasma generating apparatus in which the number of impedance matching members is less than that of the antenna elements and an impedance-matching related mechanism is formed in a relatively compact size. Moreover, it is possible to connect a single matching member to a plurality of antenna elements through an inexpensive and relatively compact distribution wire without using a large, heavy and relatively expensive distributor. Furthermore, the present invention provides a relatively compact plasma film forming apparatus using a plasma generating apparatus provided with a relatively compact impedance-matching related mechanism.

### BRIEF DESCRIPTION OF THE DRAWINGS

Figure 1 is a schematic diagram for illustrating a configuration of a plasma CVD device which is an embodiment of a plasma film formation device of the present invention.
Figure 2 is a schematic diagram of an embodiment of a plasma generating apparatus of the present invention, provided in the plasma CVD device illustrated in Fig. 1.
Figures 3A and 3B are schematic perspective diagrams for illustrating configurations of a distribution wire, and illustrate different embodiments.
Figure 4 is a schematic diagram for illustrating a configuration (top cross section) of a plasma generating apparatus which is another embodiment of the present invention.
Figures 5A and 5B illustrate examples of relation of connection among an antenna element, a distribution wire and a capacitance element in the plasma generating apparatus of the present invention, and illustrate different embodiments.

### EXPLANATION OF THE REFERENCE NUMERALS

- 10: plasma CVD device
- 12: process target substrate
- 14: reaction container
- 16: substrate table
- 18: inlet
- 19: supply pipe
- 20: outlet
- 22: antenna element
- 23: material gas dispersion chamber
- 24: gas emission plate
- 25: reaction chamber
- 26: impedance matching member
- 26a: first capacitance element
- 26b: second capacitance element
- 27: feeding line
- 28: high-frequency power source
- 29: stub
- 30: controller
- 32: first current voltage sensor
- 34: second current voltage sensor
- 40: distribution wire
- 42: branch section
- 52: first chassis
- 54: second chassis

### BEST MODE FOR CARRYING OUT THE INVENTION

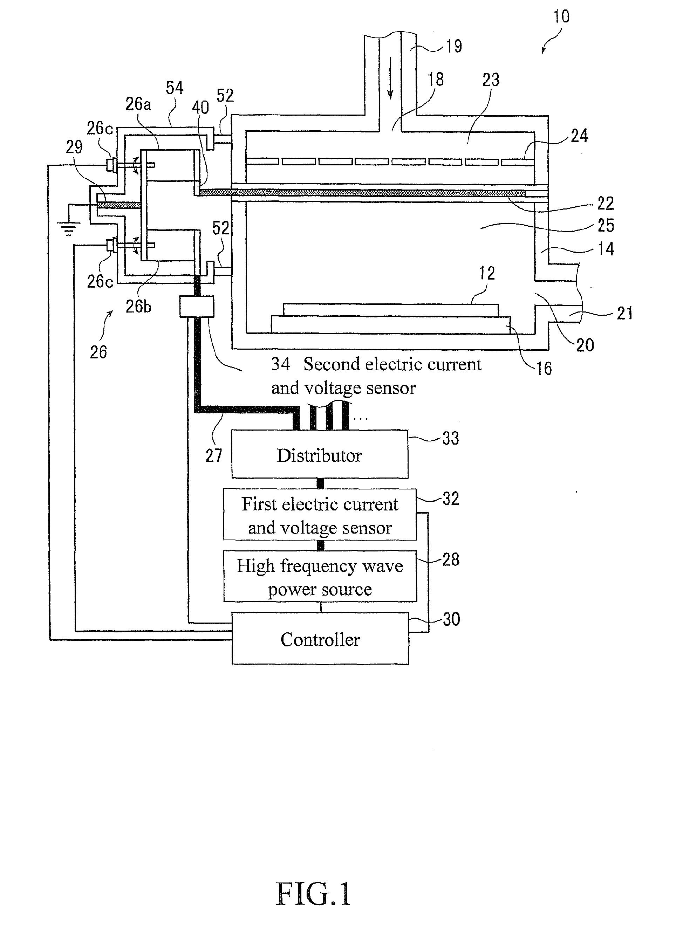

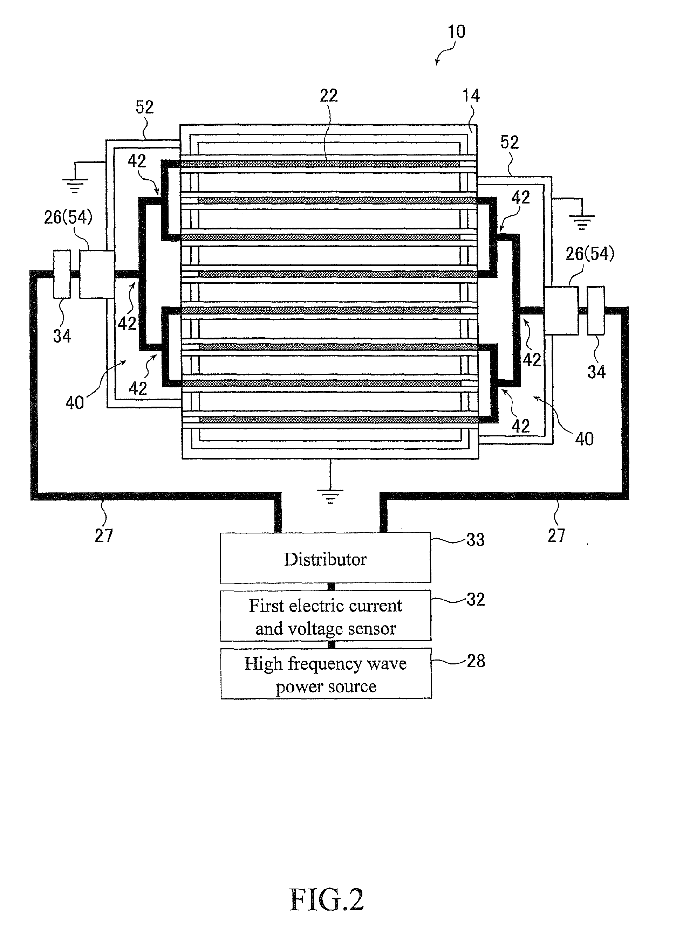

A plasma generating apparatus and a plasma film forming apparatus will be hereinafter explained in detail. Figure 1 is a schematic diagram for illustrating configuration (cross section) of a plasma CVD apparatus 10 (CVD apparatus 10). The CVD apparatus 10 is an embodiment of a plasma film forming apparatus of the present invention, composed of a plasma generation apparatus of an embodiment of the present invention. Figure 2 is a schematic diagram for illustrating configuration (top cross section) of the plasma generating apparatus of an embodiment of the present invention, provided in the CVD apparatus 10. Note Figs. 1 and 2 are diagrams for illustrating a schematic configuration of the CVD apparatus 10. Therefore, a relation between the length of an antenna element 22 to be described and the size of a distribution wire 40, for instance, is not based on the actual size of the apparatus.

The CVD apparatus 10 is configured to execute film formation processing on a process target substrate 12 (e.g., a glass substrate or a silicon wafer) using CVD. The CVD apparatus 10 includes a reaction container 14, a substrate table 16, an inlet 18, an outlet 20, a gas emission plate 24, a plurality of antenna elements 22, impedance matching members 26, distribution wires 40, a high-frequency power source 28, a controller 30, a first current voltage sensor 32, second current voltage sensors 34 and a distributor 33. The substrate table 16 is used for disposing the process target substrate 12. The inlet 18 is provided in the wall of the reaction container 14. Material gas is introduced into the reaction container 14 through the inlet 18. The outlet 20 is provided in the wall of the reaction container 14. The material gas and the like are discharged to the outside through the outlet 20 for decompression in the reaction container 14. The gas emission plate 24 is disposed in the reaction container 14. The gas emission plate 24 emits the material gas into a reaction chamber. The antenna elements 22 are disposed in the reaction container 14. The impedance matching members 26 are disposed on the outside of the reaction container 14. Each of the distribution wires 40 electrically connects each of the impedance matching members 26 and at least two antenna elements 22. The high-frequency power source 28 is configured to supply electric power to the antenna elements 22. The controller 30 is configured to control the high-frequency power source 28 and the impedance matching members 26. The first current voltage sensor 32 is configured to detect current and voltage of a high-frequency signal to be supplied to the antenna elements 22. The second current voltage sensors 34 are configured to detect current and voltage for regulating the impedance matching members 40, respectively. The distributor 33 is disposed between the first current voltage sensor 32 and the second current voltage sensors 34.

The reaction container 14 is a metal container. The wall of the reaction container 14 is grounded.
The substrate table 16 is used for disposing the process target substrate 12 while the process target substrate 12 is opposed to the antenna elements 22. A heater (not illustrated in the figure) is disposed in the interior of the substrate table 16 for heating the process target substrate 12. Additionally, the substrate table 16 is provided with a grounded electrode plate (not illustrated in the figure). The electrode plate may be connected to a bias power source. Accordingly, bias voltage may be applied to the electrode plate from the bias power source.

The inlet 18 is provided on the top side of the reaction container 14. The inlet 18 is connected to a supply pipe 19. The material gas is supplied through the supply pipe 19. The supply pipe 19 is connected to a material gas source (not illustrated in the figure). The material gas, supplied through the inlet 18, depends on types of films to be formed. In a case of the low-temperature poly-silicon TFT LCD, silane gas is preferably used for forming a silicon film, whereas TEOS is preferably used for forming a gate insulator film.

The reaction container 14 is partitioned by the gas emission plate 24. Accordingly, a material gas dispersion chamber 23 is formed on the upper side of the reaction container 14, whereas a reaction chamber 25 is formed on the lower side of the reaction container 14. The gas emission plate 24 is a plate member made of conductive material (e.g., anodized aluminum). The plate member has a plurality of through holes having diameter of roughly 0.5mm. The gas emission plate 24 emits the material gas into the reaction chamber 25 on the lower side of the reaction container 14 through the through holes at a predetermined flow speed. The gas emission plate 24 may be composed of ceramic material or a plate member on which a film is formed by CVD film formation processing. When the gas emission plate 24 is the plate member on which a film is formed by the CVD film formation processing, a grounded metal film is formed on the gas emission plate 24.
The outlet 20 is connected to a discharge pipe 21 for setting a material gas atmosphere in the reaction container 14 to be decompressed to a predetermined pressure. The discharge pipe 21 is connected to a vacuum pump (not illustrated in the figure).

The plurality of antenna elements 22 are disposed below the gas emission plate 24 in the upper part of the reaction chamber 25. The antenna elements 22 are disposed in an array while opposing to the gas emission plate 24. As illustrated in Fig. 2, the antenna elements 22 are aligned in parallel to each other on the same plane. The antenna elements 22 form an array antenna. The array antenna is composed of monopole antennas. The array antenna is disposed in parallel to the gas emission plate 24 and the process target substrate 12 disposed on the substrate table 16. As illustrated in Fig. 2, the antenna elements 22, operating as the monopole antennas, protrude from the wall of the reaction container 14. In this case, the adjacent antenna elements 22 protrude in opposite directions. Moreover, the electric supply directions of the antenna elements 22 are opposite to the electric supply direction of the adjacent antenna element 22. The antenna elements 22 are connected to the impedance matching members 26 through the distribution wires 40. The impedance matching members 26 are configured to change a property parameter for impedance matching.

Each of the antenna elements 22 is composed of a rod-shaped (or pipe-shaped) conductor having high electrical conductivity. The length of the antenna element 22 is (2n+1)/4 (where "n" is zero or a positive integer) times as large as the wavelength of a high-frequency wave to be used. The surface of each antenna element 22 is covered with a dielectric (e.g., a quartz tube). Capacity and inductance of the antenna elements 22 are adjusted by covering the rod-shaped conductor with the dielectric. Accordingly, it is possible to efficiently transmit high-frequency current along the protruding direction of the antenna elements 22 and to efficiently emit an electromagnetic wave. Thus, each of the antenna elements 22, covered with the dielectric, is attached to an opening formed in the inner wall of the reaction container 14 while electrically insulated. An end of each of the antenna elements 22 on the side of high-frequency current supply is connected to one of the impedance matching members 26 through the distribution wire 40.

The antenna elements 22 are disposed in the vicinity of the gas emission plate 24. Accordingly, electromagnetic wave, emitted by each of the antenna elements 22, forms a predetermined electromagnetic wave together with another electromagnetic wave formed in a mirror image due to the grounded metal film of the gas emission plate 24 while not affecting the adjacent antenna elements 22 nor being affected by the adjacent antenna elements 22. Moreover, the electric supply directions of the antenna elements 22 forming the array antenna are opposite to the electric supply direction of the adjacent antenna element 22. The electromagnetic waves are thereby uniformly formed in the reaction chamber 25.

Each of the distribution wires 40 electrically connects one of the impedance matching members 26 and at least two antenna elements 22. Moreover, each of the distribution wires 42 includes a plurality of branch sections 42 between each of the impedance matching members 26 and each of the antenna elements 22. A high-frequency signal is distributed into two directions at each of the branch sections 42. In the present embodiment, a portion of the distribution wire 40, extended from one of the impedance matching members 26, is branched into two directions at the first branch section. Subsequently, each of the branched portions of the distribution wire 40 is further branched into two directions at the second branch section. Additionally, in the present embodiment, four antenna elements 22 are connected to each of the impedance matching members 26 through each of the distribution wires 40. The distribution wires 40 are enclosed by a first chassis 52. The first chassis 52 is connected (electrically connected) to the reaction container 14. Accordingly, the first chassis 52 is grounded. The distribution wires 40 will be hereinafter explained in detail.

Each of the impedance matching members 26 is composed of a first capacitance element 26a, a second capacitance element 26b and servomotors 26c. One end of the first capacitance element 26a is connected to one of the distribution wire 40. One end of the second capacitance element 26b is connected to one of feeding lines 27. Each of the first and second capacitance elements 26a and 26b is provided with the servomotor 26c. The servomotors 26c are configured to adjust capacitance of the first capacitance element 26a and that of the second capacitance element 26b. The other ends of the first and second capacitance elements 26a and 26b are connected to a second chassis 54 through a stub 29. The second chassis 54 covers the impedance matching members 26. The second chassis 54 is electrically connected to the first chassis 52 connected to the reaction container 14. The second chassis 54 is thus grounded. The stub 29 is connected to the second chassis 54 covering the impedance matching members 26. The stub 29 is also thus grounded. Each of the first and second capacitance elements 26a and 26b is allowed to freely adjust capacitance (property parameter). Specifically, electrodes which are components of each of the first and second capacitance elements 26a and 26b, are allowed to change their gap distance. The capacitance adjustment is achieved when the servomotor 26c adjusts positions of the electrodes. Capacitance adjustment of the first and second capacitance elements 26a and 26b, simultaneously executed with adjustment of a frequency of a high-frequency signal generated by a high-frequency power source 28 to be described, is executed for correcting impedance condition now being out of matching, which is caused by electric loads of the antenna elements 22 in generating plasma.

The high-frequency power source 28 is composed of a high-frequency oscillation circuit and an amplifier (not illustrated in the figure). The high-frequency power source 28 is configured to change an oscillation frequency in accordance with a signal from the controller 30.
The controller 30 is a control section for changing the oscillation frequency of the high-frequency power source 28 and for adjusting the impedance matching members 26 in accordance with the signals detected by the first and second current voltage sensors 32 and 34. The oscillation frequency of the high-frequency oscillation circuit is allowed to be changed, for instance, in a range of 10-130MHz in accordance with types of processing to be executed for the substrate. In a variety of impedance matching operations to be described, the oscillation frequency of the high-frequency oscillation circuit may be minutely adjusted for minutely adjusting an impedance matching condition. Note the oscillation frequency of the high-frequency power source 28 may not be variable, for instance, when used for a type of processing not requiring any changes or minute adjustments of the oscillation frequency.

The first current voltage sensor 32 is configured to detect current and voltage in the vicinity of the output end of the high-frequency power source 28 for detecting whether or not a high-frequency signal is supplied to the antenna elements 22 from the high-frequency power source 28 while impedance matching is achieved. The first current voltage sensor 32 is connected to the impedance matching members 26 through the distributor 33 and the feeding lines 27. The second current voltage sensors 34 are disposed in the vicinity of the input ends of the impedance matching members 26, respectively. The second current voltage sensors 34 are configured to detect current and voltage for adjusting the impedance matching members 26, respectively. When impedance matching is not achieved, a reflected wave of the high-frequency signal is generated in the connection portions between the feeding lines 27 and the antenna elements 22. Then, a phase difference is occurred between current and voltage. Therefore, it is possible to detect whether each of the antenna elements is in the impedance matching condition or out of the impedance matching condition based on current and voltage detected by the first and second current voltage sensors 32 and 34. The signals, detected by the first and second current voltage sensors 32 and 34, are provided to the controller 30.

The controller 30 is configured to determine whether each of the antenna elements is in the impedance matching condition or out of the impedance mismatching condition based on the detection signals from the first and second current voltage sensors 32 and 34. More specifically, the controller 30 is configured to generate a control signal for controlling a capacitance adjusting operation of the impedance matching members 26 in accordance with the determination result. Subsequently, the controller 30 is configured to transmit the generated control signal to the servomotors 26c of the impedance matching member 26b which is connected through the distribution wire 40 to the antenna elements 22 required for the impedance matching. The operation of the servomotor 26c is controlled by the generated control signal. Accordingly, capacitance of the second capacitance element 26b is adjusted and the condition out of the impedance matching is corrected.

The distributor 33 is a heretofore known distributor. The distributor 33 distributes a high-frequency signal, outputted by the high-frequency power source 28, to a plurality of feeding lines (two feeding lines 27 in the present embodiment illustrated in Fig. 2, respectively, with the same level of electric power while impedance matching is maintained. The distributor 33 is composed of a resistor, a coil, a condenser and the like. The same number of antenna elements 22 protrude from two opposed walls of the reaction container 14. Additionally, a plurality of the ends of the antenna elements 22 on a side of the high-frequency current supply are disposed in the vicinity of the two opposed walls of the reaction container 14, respectively. Four antenna elements 22, protruding from one of the opposed walls of the reaction container 14, are connected to one of the impedance matching members 26 through the distribution wire 40. This will be hereinafter explained, but, the size of the distribution wire 40 is limited. Therefore, the impedance matching members 26 are disposed in positions relatively close to the walls of the reaction container 14. The aforementioned two opposed walls of the reaction container 14 are separated at least through the length of the antenna element 22. The impedance matching members 26 are also required to be spatially separated to some extent. Basically, disposition and size of the distributor 33, composed of a heretofore known distributor, is not particularly limited. The high-frequency electric current, equally distributed by the distributor 33, is supplied to a plurality of antenna elements 22 through two relatively-long feeding lines 27 (furthermore, through the impedance matching members 26 and the distribution wires 40) while impedance matching is achieved.

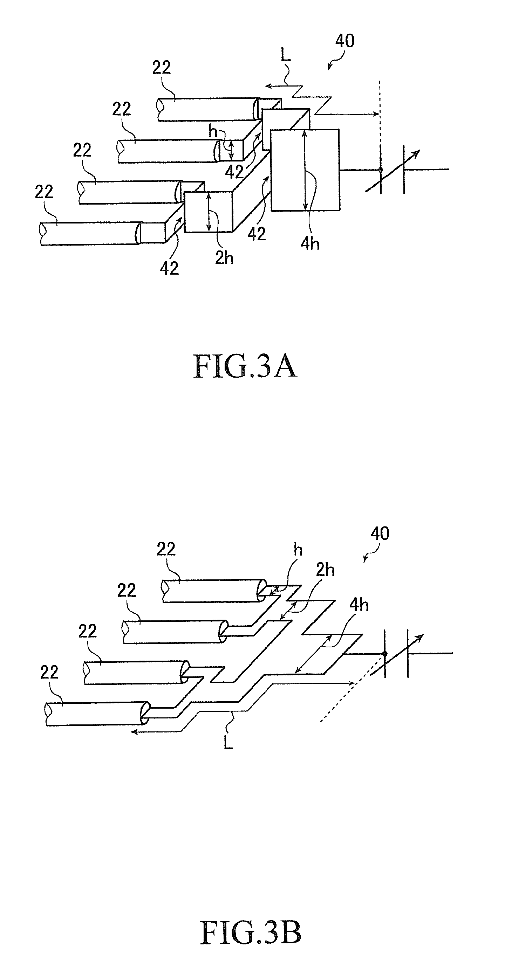

Figures 3A and 3B are schematic perspective diagrams for explaining a configuration of the distribution wire 40. Embodiments, illustrated in Figs. 3A and 3B, are different from each other. The distribution wire 40 includes a plurality of branch sections 42 between each of the impedance matching members 26 and the antenna elements 22. Each of the branch sections distributes a high-frequency signal into two directions. In the present embodiment, the total number of the branch sections 42 is 3 (=1+2). The distribution wire 40 is made of a plate conductor. In the present embodiment, the distribution wire 40 is made of a copper plate. Copper has a relatively high electric conductivity. Therefore, copper is preferable as the material of the distribution wire 40. When the distribution wire 40 is divided into two portions at each of the branch sections 42, the divided portions of the distribution wire 40 which are located on a side of the antenna element 22 with reference to a position of each of the branch sections 42, have half the width H of the portion of the distribution wire 40 which are located on a side of the impedance matching member 26 with reference to the position of each of the branch sections 42. The width H is herein generally perpendicular to a travel direction of a high-frequency signal transmitted from the impedance matching members 26 to the antenna elements 22. In other words, as illustrated in Fig. 3, the width H of the distribution wire 40 is reduced in a stepwise manner (i.e., H=4h, H=2h and H=h) toward the antenna elements 22 from the impedance matching member 26 at each of the branch sections 42. The portions of the distribution wire 40, having width h (i.e., H=h), are joined to the ends on the power supply ends of the antenna elements 22. The width h is the same as diameter of the antenna element 22 (e.g., 6.0mm). As illustrated in Fig. 3A, the width direction of the width H may be generally perpendicular to a plane that the antenna elements 22 are disposed. Alternatively, as illustrated in Fig. 3B, the width direction of the width H may be generally parallel to the plane that the antenna elements 22 are disposed. Thickness t of the distribution wire 40 composed of a copper plate is sufficiently thinner than that of the width H. For example, the thickness t is set to be roughly 1 mm (t=1).

On the other hand, a portion of the distribution wire 40 having width 4h (i.e., H=4h) is connected to the impedance matching member 26. In the present embodiment, the distribution wire 40 is connected to the first capacitance adjustment element 26a of the impedance matching member 26. The portion of the distribution wire 40 having width 4h (i.e., H=4h) may be connected to the first capacitance adjustment element 26a of the impedance matching member 26, for instance, without changing the width of the portion. Alternatively, when an electric wire is smaller in a diameter in comparison to the width 4h (i.e., H=4h) of the distribution wire 40, so that capacitance adjustment element 26a is small, for instance, the distribution wire 40 and the capacitance adjustment element 26a may be jointed and electrically connected through the electric wire. Yet alternatively, the distribution wire 40 and the capacitance adjustment element 26a may be connected through a heretofore known high-frequency circuit substrate, for instance. The way how to join the distribution wire and the impedance matching member is not particularly limited. Additionally, the distribution wire 40 may be folded in an arbitrary shape. In this case, the structure of the distribution wire 40 is further compactly formed than the example of Fig. 3, for instance.

The high-frequency signal, supplied through the feeding line 27, travels towards the antenna elements 22 from the impedance matching member 26. For example, when a high-frequency signal having high frequency of 10-130MHz travels through a conductor, most of the high-frequency current travels through only the surface portion of the conductor. Thickness of the distribution wire 40 composed of a copper plate is sufficiently smaller than the width H. It is possible to assume that a cross sectional area in an arbitrary portion of the distribution wire 40, through which a high-frequency current passes, is proportional to the width H (note "t" is herein negligible). Magnitude of impedance is inversely proportional to that of the width H. The distribution wire 40 is branched into two paths of a high-frequency signal in each of the branch sections 42. However, the width H of each of the branched portions of the distribution wire 40 becomes half the width H of the pre-branched portion of the distribution wire 40 every time when the distribution wire 40 is branched. Accordingly, a property (i.e., impedance) is not changed before and after the branch. Additionally, a portion of the distribution wire 40 having width 4h (i.e., H=4h) is branched into two portions having width 2h (i.e., H=2h). Thus, the two branched portions have the same width. Accordingly, electric power of the high-frequency current will be equally distributed to the branched portions. In other words, a plurality of antenna elements 40, connected to the distribution wire 40, are respectively provided with a high-frequency signal having the same amount of electric power in the identical impedance matching condition.

Note in the distribution wire 40, conductive path lengths L of a high-frequency signal, extending from the impedance matching members 26 to the antenna elements 22, are set to be equal to or less than one-tenth of the wavelength of the high-frequency signal, respectively. Note the origin of the length L in each of the impedance matching members 26 corresponds to a terminal portion of a capacitance component of the capacitance adjustment element composing the impedance matching member 26. When each of the impedance matching members is composed of a reactance component (e.g., a coil) or a resistance component, the terminal portion of each of the components is set to be the origin of the length L. For example, when a high-frequency signal of 80MHz is supplied by the high-frequency power source 28, the wavelength of the high-frequency signal is 3.8m. For example, the conductive path length L of the distribution wire 40 is equal to or less than 38cm. Note each of the antenna elements 22 of the present embodiment is enclosed by a dielectric, a quartz pipe. The effective wavelength of a high-frequency signal in each of the antenna elements 22 is relatively small. The effective wavelength has roughly 50cm which is the one-fourth wavelength (note the full wavelength corresponds to roughly 2.0m).

When the length L of a transmission path of a high-frequency signal in the distribution wire 40 is set to be one-tenth or less of the wavelength of a high-frequency signal, it is possible to treat the distribution wire 40 as a so-called lumped-constant circuit. Therefore, additional mode is not generated in the distribution wire 40 especially by the influence of the branch section 42 of the distribution wire 40. Additionally, while plasma is being generated, a high-frequency signal wave stands in portions of the distribution wire 40 which extends from the impedance matching members 26 to the tip of the antenna elements 22 in a resonance condition. Thus large current (e.g., the effective value of 10A) flows therein. The distribution wire 40 is composed of only a copper plate. The structure of the distribution wire 40 is accordingly relatively simple and the cost thereof is low. However, the distribution wire 40 has relatively tolerant to the current, even to the current in a resonance state. Moreover, the aforementioned additional mode is not generated, thereby increasing the current in the distribution wire 40. In short, it is possible to stably distribute and supply a high-frequency signal to each of the antenna elements 22 using the distribution wire 40.

For example, when a heretofore known distributor may be used instead of the distribution wire 40, the distributor is obviously required to have sufficiently tolerance to the current in a resonance state. The heretofore known distributor is composed of a resistor, a coil, a condenser and the like, and each of the components has relatively low tolerance to the current. When the distributor has sufficiently tolerance to the current in a resonance state, the size and the weight of the distributor will be inevitably large and the cost thereof will be relatively high. On the other hand, when a distributor is employed for the connection between each of the impedance matching members and at least two antenna elements in a plasma generating apparatus, highly advantageous effects are achieved for the size and the cost of the plasma generating apparatus.

The distribution wire 40 may be disposed together with each of the impedance matching members 26 in a single chassis which encloses the impedance matching members 26. The distribution wire 40 does not require to be electrically grounded. However, the distribution wire 40 is preferably enclosed by a grounded chassis for preventing noise contamination in a high-frequency signal to be carried in the distribution wire 40, on the other hand, for preventing influence of an electromagnetic wave emitted by the distribution wire 40 on the other electric devices.

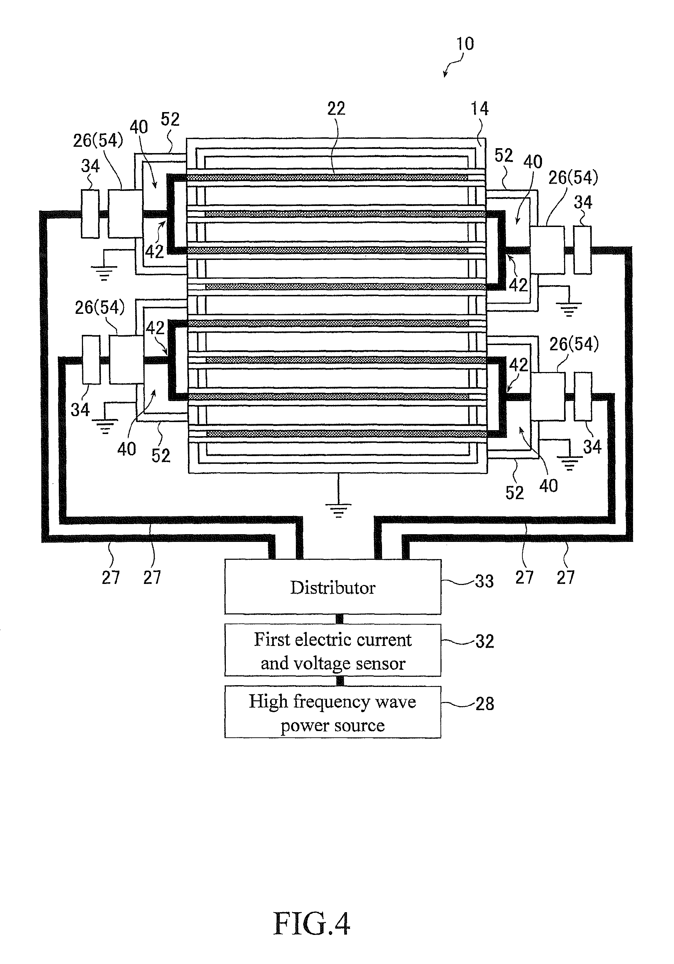

Figure 4 is a schematic cross sectional top view of a plasma generating apparatus of another embodiment of the present invention. In the plasma generating apparatus of the present invention, there is no particular limitation to the number of branch sections in the distribution wire. Additionally, there is no particular limitation to the number of antenna elements to be connected to a single distribution wire. As illustrated in Fig. 4, for instance, only one branch section 42 may be provided and only two antenna elements 22 may be connected to a single distribution wire 40. Moreover, there is no particular limitation to the number of distribution wires to be disposed for an array antenna which is composed of a plurality of aligned antenna elements. As illustrated in Fig. 4, for instance, two impedance matching members 26 may be disposed on the side of the high-frequency current supply ends of a plurality of antenna elements 22 composing a single array antenna. Additionally, the number of the distribution wires 40 may be matched with totally four impedance matching members 26. In the embodiment illustrated in Fig. 4, the number of distributions, set by the distributor 33, is four (the number of distributions is two in the embodiment of Fig. 2). Four feeding lines 27 are connected to four impedance matching members 26 on a one-to-one basis. As described above, the conduction path length L of a high-frequency signal in the distribution wire 40 depends on the wavelength of the high-frequency signal. For example, in a case that plasma is generated using a high-frequency signal of the relatively short wavelength (i.e., relatively high frequency), the conduction path length L will be relatively short. Accordingly, the size of the distribution wire 40 is required to be relatively small. On the other hand, in a case that plasma is generated in a relatively wide region, it is necessary to use relatively large number of antenna elements 22. As illustrated in Fig. 4, for instance, the plasma generating apparatus of the present invention is easily operable for the cases, by reducing the number of branch sections 42 in the distribution wire 40 to some extent and by increasing the number of the distribution wires 40 to some extent. Even when the number of the distribution wires 40 is increased to some extent, the apparatus is operable for the cases by increasing the number of feeding lines to be distributed by the distributor to some extent. With the plasma generating apparatus of the present invention, it is possible to stably generate plasma, for instance, in a relatively wide frequency range of 10MHz-2GHz.

In the CVD apparatus 10 of this type, material gas is introduced into the reaction container 14 through the inlet 18, whereas a vacuum pump (not illustrated in the figure), connected to the outlet 20, is operated. Accordingly, a vacuum atmosphere of roughly 1 to several hundred Pa is normally generated in the reaction container 14. When a high-frequency signal is supplied to the antenna elements 22 under the condition, electromagnetic waves are emitted in the surroundings of the antenna elements 22. As a result, plasma is generated in the reaction container 14, and the material gas, emitted by the gas emission plate 24, is excited and radicals are produced. In this case, the generated plasma has electric conductivity. The electromagnetic waves, emitted by the antenna elements 22, are thereby easily reflected by the plasma. Accordingly, the electromagnetic waves are localized in a limited area around the antenna elements 22. As a result, plasma is formed and localized in the vicinity of the antenna elements 22.

In this case, since the plasma is generated and localized in the surroundings of the antenna elements 22 emitting electromagnetic waves, electric loads of the antenna elements 22 are accordingly changed. Therefore, the antenna elements 22 become out of the impedance matching condition from the matched impedance. Additionally, reflectance of a high-frequency signal supplied by the high-frequency power source 28 becomes higher at the connection portions with the antenna elements 22. As a result, electric power is not sufficiently supplied. In this case, the electric load changes in the antenna elements 22 are different from each other. How far away the impedance matching conditions are for the antenna elements 22, is accordingly different from each other. Therefore, the electromagnetic waves, emitted by the antenna elements 22, are also distributed. As a result, density distribution of the generated plasma is also spatially changed. The spatial change of the plasma density distribution is not preferable for the film formation of the process target substrate 12 and the like. Therefore, it is necessary to achieve impedance matching in each of the antenna elements 22 for generating uniform plasma by making the antenna elements 22 constantly emit the electromagnetic waves.

Impedance matching of the antenna elements 22 is specifically executed by adjusting frequency of a high-frequency wave and capacity of the capacitance element 26b, such that current and voltage of a high-frequency signal to be supplied may have no phase difference and the impedance of the feeding line 27 (e.g., 50Ω) may be matched with impedance of a plurality of antenna elements 22 and the distribution wire 40 connected to each of the impedance matching members 26 by the first and second capacitance elements 26a and 26b of the corresponding impedance matching member 26. In the adjustment, information of current and voltage detected by the first and second current and voltage sensors 32 and 34 is supplied to the controller 30 as a detection signal. The controller 30 is configured to set frequency of a high-frequency signal and further capacitance of the second capacitance element 26b based on the detection signal. Accordingly, a control signal is generated for controlling both the high-frequency power source 28 and the servo motors 26c. The control signal is thus supplied to the high-frequency power supply 28 and the servo motors 26c, and impedance in the signal wire 27 and impedance in the distribution wire 40 and the antenna elements 22 are thereby matched.

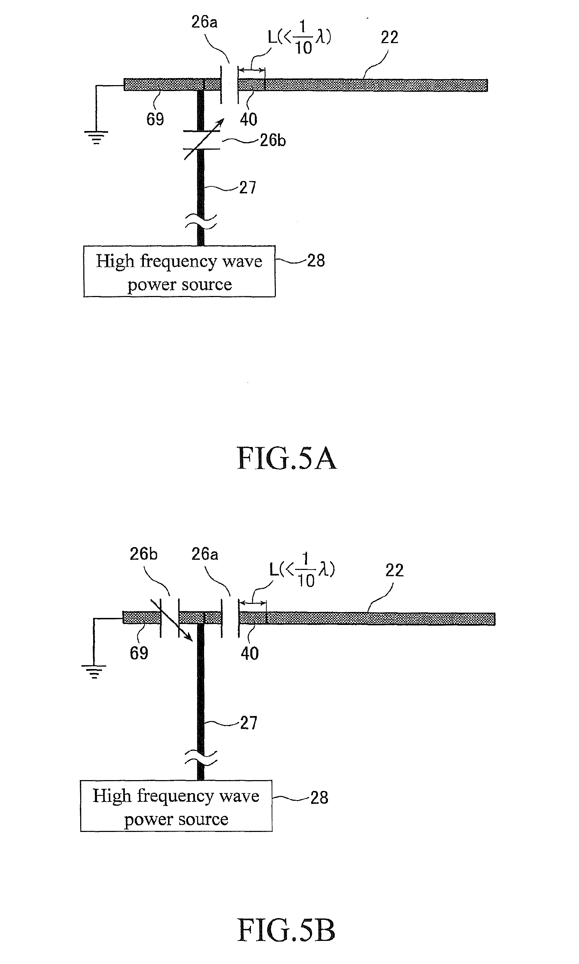

Figure 5A illustrates a connection relation among the antenna element 22, the distribution wire 40 and the capacitance elements 26a and 26b. Impedance of the distribution wire 40 is roughly constant in the longitudinal direction regardless of the number of antenna elements 22 or regardless of existence of a branch. This is because the width H of the distribution wire 40 is reduced by half whenever the distribution wire 40 is branched into two portions at a branch section 42. Additionally, the length L of the distribution wire 40 is equal to or less than one-tenth of the wavelength λ, and is thus sufficiently short. It is possible to treat the distribution wire 40 as a lumped constant circuit, and an additional mode of a high-frequency wave is not generated. The CVD apparatus 10 is capable of correcting the state out of impedance matching which is occurred in plasma generation by simultaneously adjusting frequency of a high-frequency signal and capacity of the second capacitance element 26b of the impedance matching members 26. Other than the example of Fig. 5A, for instance, the impedance matching member 26 may be configured as illustrated in Fig. 5B. Specifically, the first and second capacitance elements 26a and 26b may be serially connected to the antenna element 22, and an electric feeding point of a high-frequency signal may be provided between the first and second capacitance elements 26a and 26b. In this case, it is possible to achieve impedance matching of each of the antenna elements 22 and the signal line 27 by simultaneously controlling frequency of a high-frequency signal and capacity of the capacitance element 26b.

In the present embodiment, a capacitance element (capacitor) is used for achieving impedance matching in the antenna element 22. However, inductance (i.e., a property parameter) may be controlled using an inductance element (inductor). A high-frequency signal which is to be controlled in the CVD apparatus 10, is a signal shared by the antenna elements 22. Therefore, a single capacitance element (i.e., the second capacitance element 26b) may be set to be controlled in the impedance matching member correspondingly provided to each of the antenna elements 22. Additionally, frequency of a high-frequency signal supplied to and shared by the antenna elements 22 is controlled. Therefore, it is possible to commonly achieve impedance matching in the antenna elements while it is possible to minutely adjust impedance matching in each of the antenna elements using the capacitance element 26b. Note the number of capacitance elements to be controlled in the impedance matching member is not limited to one. For example, in addition to the second capacitance element, the first capacitance element may be a capacity-adjustable capacitance element in the impedance matching member of the embodiment illustrated in Fig. 2. In achieving impedance matching, capacity of the first capacitance element may be adjusted together with the second capacitance element.

In the aforementioned embodiment, frequency of a high-frequency signal and capacity of the capacitance element are configured to be controlled. In the present invention, however, either frequency of a high-frequency signal or capacity of a capacitance element may be configured to be controlled. For example, when the impedance matching is achieved in the present apparatus before plasma is generated, it is possible to roughly achieve impedance matching by adjusting either frequency of a high-frequency signal or capacity of a capacitance element. To accurately achieving impedance matching, however, it is preferable to control both frequency of a high-frequency signal and capacity of a capacitance element.

As described above, the plasma generating apparatus and the plasma film forming apparatus are explained in detail. However, the present invention is not limited to the aforementioned embodiment. Obviously, a variety of changes and modifications are allowed without departing from the scope of the present invention. For example, the plasma generating apparatus of the present invention is preferably applicable to an etching apparatus in addition to a CVD apparatus.

## Claims

1. A plasma generating apparatus using an antenna array including a plurality of antenna elements aligned on an identical plane, each of the antenna elements composed of a rod-shaped conductor with a surface thereof covered with a dielectric, the plasma generating apparatus comprising:
a high-frequency power source for generating a high-frequency signal to be supplied to each of the antenna elements of the antenna array;
impedance matching members connected to feeding lines for supplying the high-frequency signal to the antenna elements, the impedance matching members configured to change a property parameter used for impedance matching;
distribution wires correspondingly disposed to the impedance matching members, respectively, each of the distribution wires connecting each of the impedance matching members and at least two antenna elements; and
a control unit configured to simultaneously adjust impedance matching conditions of at least two of the antenna elements connected to each of the impedance matching members through each of the distribution wires by changing the property parameter of each of the impedance matching members.

2. The plasma generating apparatus according to claim 1,
further comprising a distributor for distributing a high-frequency signal to be generated by the high-frequency power source to the feeding lines, and
wherein the impedance matching members are correspondingly provided to the feeding lines, respectively.

3. The plasma generating apparatus according to claim 1 or 2, wherein each of the distribution wires includes a single or plurality of branch sections between each of the impedance matching members and each of the antenna elements, and the high-frequency signal is two-directionally distributed in each of the single or the plurality of the branch sections.

4. The plasma generating apparatus according to claim 3, wherein each of the distribution wires is composed of a plate conductor, and the plate conductor is two-directionally branched in each of the single or the plurality of the branch sections.

5. The plasma generating apparatus according to claim 4, wherein a width of the plate conductor on a side of the antenna elements with a reference to each of the branch sections is reduced to a half of that of the plate conductor on a side of the impedance matching members with a reference to each of the branch sections, the width defined in a perpendicular direction to a travel direction of the high-frequency signal to be carried from each of the impedance matching members to the antenna elements.

6. The plasma generating apparatus according to anyone of claims 1 to 5, wherein path length of the high-frequency signal, extending from each of the impedance matching members to the corresponding antenna elements in each of the distribution wires, is equal to or less than one-tenth of wavelength of the high-frequency signal.

7. The plasma generating apparatus according to anyone of claims 1 to 6,
wherein the property parameter is a capacity parameter used for impedance matching, and
each of the impedance matching members includes a capacitance element configured to change the capacity parameter.

8. A plasma film forming apparatus, comprising:
a chamber accommodating the plasma generating apparatus according to anyone of claims 1 to 7 and
means for supplying material gas and reaction gas into the chamber, and
wherein at least either of the material gas and the reaction gas is provided to plasma generated by the plasma generating apparatus, and film formation processing is executed on a surface of a predetermined substrate disposed in the chamber.
